# DEMANDE DE BREVET EUROPEEN

(11) **EP 4 658 027 A1**
(43) Date de publication de la demande: **03.12.2025**
(21) Numéro de dépôt: 25178964.0
(22) Date de dépôt: 27.05.2025
(51) Int. Cl.: H10F 19/80

(54) **MODULE PHOTOVOLTAÏQUE ET PROCÉDÉ DE FABRICATION**

(30) Priorité: 29.05.2024 FR 2405532
(71) Demandeur: Commissariat à l'Energie Atomique et aux Energies Alternatives, 75015 Paris (FR); Electricité de France, 75008 Paris (FR)
(72) Inventeur: COUDERC, Romain, 38054 GRENOBLE Cedex 09 (FR); PIROT-BERSON, Lucie, 73000 CHAMBERY (FR); CABAL, Raphaël, 38054 GRENOBLE Cedex 09 (FR); DENIS, Christine, 38054 GRENOBLE Cedex 09 (FR)
(74) Mandataire: Ipsilon

(57) **Abrégé**

Module photovoltaïque (M), comportant une face avant (41) et une face arrière (42), le module photovoltaïque comportant un empilement multicouche comprenant au moins :
- une première couche de protection transparente en verre,
- un encapsulant (2) en matériau polymère, par exemple de type élastomère transparent, dans lequel est encapsulé ou enrobé au moins une cellule photovoltaïque (20), voire des cellules photovoltaïques (20),
- une deuxième couche de protection (1), et
- au moins une couche barrière (30), disposée entre la couche de protection transparente en verre et l'encapsulant (2), la couche barrière (30) comportant au moins 95 % en masse de SiOxNy,
avec x + y = 2.

## Description

### Domaine technique

La présente invention concerne un module photovoltaïque et un procédé de fabrication d'un tel module. Le module photovoltaïque comporte au moins une cellule photovoltaïque noyée dans un encapsulant comportant un matériau polymère.

### Technique antérieure

Un module photovoltaïque comporte une ou des cellules photovoltaïques destinées à convertir une énergie solaire en énergie électrique. Un tel module photovoltaïque contenant une ou des cellules photovoltaïques, par exemple des cellules silicium hétérojonction (SHJ), est sensible à l'humidité. L'humidité peut provoquer la migration de certains sels, ions ou substances solubles présents dans le verre vers la ou les cellules photovoltaïques.

Il est connu d'utiliser une couche de SiOx déposée sur les faces avant et arrière de la cellule photovoltaïque SHJ pour empêcher la contamination par le sodium issu du verre. Cette solution requiert cependant de réaliser les dépôts de SiOx sur les deux faces des cellules photovoltaïques SHJ pour obtenir une protection complète de la cellule dans une configuration verre/verre.

La demande US 2011/0094781 enseigne d'empêcher la diffusion du sodium provenant du verre vers les dispositifs électroniques en contact avec le verre grâce à un film. Le dépôt du film est obtenu par une réaction d'hydrolyse-condensation d'un mélange de methyltrialkoxysilane et de tetraalkoxysilane à une température de 400 °C ou moins. Le film obtenu est disposé entre le verre et le dispositif à protéger, en contact avec ceux-ci.

Cependant, il existe un besoin pour améliorer encore et faciliter la protection d'un module photovoltaïque, et pour améliorer sa durabilité, notamment dans un environnement humide, par exemple un environnement de chaleur humide.

### Exposé de l'invention

La présente invention répond à tout ou partie de ce besoin et a ainsi pour objet un module photovoltaïque, comportant une face avant et une face arrière, le module photovoltaïque comportant un empilement multicouche comprenant au moins :
- une première couche de protection transparente en verre, notamment disposée en face avant,
- un encapsulant en matériau polymère, par exemple de type élastomère transparent, dans lequel est encapsulé ou enrobé au moins une cellule photovoltaïque, voire des cellules photovoltaïques,
- une deuxième couche de protection, notamment disposée en face arrière du module, notamment en verre ou à base de polymères multicouches définissant une face arrière dite « *backsheet* », et
- au moins une couche barrière, disposée entre la couche de protection transparente en verre et l'encapsulant, la couche barrière comportant au moins 95 % en masse de SiOxNy, avec x + y = 2, et notamment x ≥ y.

L'invention a également pour objet, indépendamment ou en combinaison avec ce qui précède,un module photovoltaïque, comportant une face avant et une face arrière, le module photovoltaïque comportant un empilement multicouche comprenant au moins :
- une première couche de protection transparente en verre disposée en face arrière,
- un encapsulant en matériau polymère, par exemple de type élastomère transparent, dans lequel est encapsulé ou enrobé au moins une cellule photovoltaïque, voire des cellules photovoltaïques,
- une deuxième couche de protection, notamment en verre ou à base de polymères multicouches définissant une face arrière dite « *backsheet* », et
- au moins une couche barrière, disposée entre la couche de protection transparente en verre en face arrière et l'encapsulant, la couche barrière comportant au moins 95 % en masse de SiOxNy,
avec x + y = 2, et notamment x ≥ y.

Certains sels, ions ou substances solubles présents dans la ou les couches de verre peuvent être susceptibles de migrer vers les cellules photovoltaïques, notamment dans des conditions humides, et de provoquer une dégradation des cellules photovoltaïques. On parle de lixiviation pour le mécanisme de libération des ions par le verre. L'utilisation de la couche barrière selon l'invention permet d'éviter avantageusement une telle contamination, notamment lorsque le module photovoltaïque est placé en milieu humide. En particulier, la couche barrière vient bloquer la diffusion de l'humidité et la migration des sels, ions ou substances solubles, notamment des ions sodium, du verre vers les cellules photovoltaïques. Ainsi, l'invention permet d'améliorer la durabilité du module photovoltaïque face à la dégradation en DH (chaleur *humide*/*damp-heat*) et éventuellement face à la dégradation PID (en anglais *Potential Induced Degradation*) pouvant être responsable de la migration des ions sodium vers la cellule photovoltaïque.

### Résumé de l'invention

### Module photovoltaïque

Le module photovoltaïque comporte ainsi une ou des cellules photovoltaïques disposées entre une face avant et une face arrière séparées par une tranche du module photovoltaïque, et qui sont reliées électriquement entre elles par des conducteurs de liaison et immergées dans une couche d'encapsulant ou entre deux couches avant et arrière de matériau d'encapsulation formant toutes les deux l'encapsulant.

La première couche de protection transparente en verre peut être disposée en face avant du module. En variante, la première couche de protection transparente en verre peut être disposée en face arrière du module.

La deuxième couche de protection peut être disposée en face arrière du module, étant notamment en verre ou à base de polymères multicouches définissant une face arrière.

La couche de protection formant la face avant peut être réalisée dans un ou des matériaux transparents choisi dans la liste suivante, qui n'est pas limitative : verre, matériau composite, matière plastique, polymère.

La couche de protection formant la face arrière peut être réalisée dans un ou des matériaux choisis dans la liste suivante, qui n'est pas limitative : verre, matériau composite, matière plastique, polymère, métaux. Dans le cas où les deux couches de protection sont réalisées en verre, on parle de module biverre.

Au moins l'une des deux couches de protection peut être en verre. La couche de protection en verre peut être disposée en face avant. La couche de protection en verre peut être disposée en face arrière. Dans un mode de réalisation, les deux couches de protection sont en verre.

La face arrière peut être transparente ou non transparente.

La couche barrière peut comporter au moins 96 % en masse de SiOxNy, voire au moins 97 %, voire encore au moins 98 %, mieux au moins 99 % en masse de SiOxNy. La couche barrière peut, notamment, être constituée par du SiOxNy.

Les valeurs de x et y peuvent varient respectivement dans les intervalles [0 ;2] et [0 ;2]. Les valeurs de x et y peuvent être respectivement de 0 et 2 ou de 1 et 1 ou encore de 2 et 0. Les valeurs de x et y peuvent ne pas être entières. Les valeurs de x et y peuvent être des nombres décimaux.

La couche barrière peut comporter uniquement du SiOx, avec notamment x=2. En variante, la couche barrière peut comporter uniquement du SiNy, avec notamment y=2.

Dans un mode de réalisation, on peut avoir x non nul, x ≥ y et x + y = 2. Les valeurs de x et y peuvent varient respectivement dans les intervalles ]0 ;2] et [0 ;2[. Les valeurs de x et y peuvent être respectivement de 1 et 1 ou encore de 2 et 0. Les valeurs de x et y peuvent ne pas être entières. Les valeurs de x et y peuvent être des nombres décimaux.

La couche barrière peut ne pas comporter uniquement du SiN2.

La couche barrière peut comporter au moins 96 % en masse de SiO2, voire au moins 97 %, voire encore au moins 98 %, mieux au moins 99 % en masse de SiO2. La couche barrière peut comporter uniquement du SiO2.

Dans un exemple de réalisation, la couche barrière peut comporter 57% de O2, 39% de Si et 4% de N.

La couche barrière peut être continue. La couche barrière peut comporter une épaisseur sensiblement uniforme. La couche barrière peut être conformante, recouvrant bien la couche de protection transparente en verre sans laisser de portion de la couche de protection transparente en verre non recouverte.

Une épaisseur de la couche barrière peut être supérieure à 50 nm, voire supérieure à 70 nm, voire supérieure à 80 nm, voire encore supérieure à 90 nm, mieux supérieure à 100 nm, étant par exemple de l'ordre de 110 à 150 nm.

L'épaisseur peut ainsi être suffisante pour constituer une barrière à la migration de certaines espèces, notamment des ions sodium, de la couche de protection en verre vers l'encapsulant et la ou les cellules photovoltaïques.

L'épaisseur peut par ailleurs être choisie de manière à ne pas affecter la transparence de l'empilement multicouche.

Une épaisseur de la couche barrière peut être inférieure à 250 nm, voire inférieure à 200 nm, voire encore inférieure à 180 nm, mieux inférieure à 160 nm, voire encore inférieure à 150 nm.

L'épaisseur peut être uniforme ou sensiblement uniforme sur toute la surface recouverte.

La transparence de la couche barrière peut être suffisante. Dans un mode de réalisation, la transmittance de la couche barrière déposée sur la couche de protection en verre, par mesure de la transmittance du verre+SiO, peut être de l'ordre de 92% au-dessus de 400 nm.

### Encapsulant

L'encapsulant peut être formé à partir d'au moins un film avant et/ou un film arrière. Il peut comporter un seul film d'un côté de la ou des cellules photovoltaïques, ou en variante deux films de part et d'autre de celles-ci. Les films peuvent être semblables ou différents, notamment de par leur matériau et/ou leur épaisseur.

L'encapsulant peut entourer complètement la ou les cellules photovoltaïques.

En variante, l'encapsulant peut recouvrir la ou les cellules photovoltaïques d'un seul côté de celles-ci.

Par le terme « encapsulant » ou « encapsulé », il faut comprendre que la ou les cellules photovoltaïques sont disposées dans un volume, par exemple hermétiquement clos vis-à-vis des liquides et des gaz, au moins en partie formé par au moins deux films de matériau(x) d'encapsulation, réunis entre eux après lamination pour former l'ensemble encapsulant.

En effet, initialement, c'est-à-dire avant toute opération de lamination, l'encapsulant est constitué par au moins deux films de matériau(x) d'encapsulation, entre lesquels la pluralité de cellules photovoltaïques est encapsulée.

Toutefois, pendant l'opération de lamination des films, les films de matériau d'encapsulation fondent pour ne former, après l'opération de lamination, qu'un seul ensemble solidifié dans lequel sont noyées ou enrobées les cellules photovoltaïques.

L'encapsulant peut comporter au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

Dans un mode de réalisation, l'encapsulant peut être choisi dans la liste suivante, qui n'est pas limitative : EVA, POE.

L'encapsulant peut par exemple être différent de l'EVA.

L'épaisseur de l'encapsulant peut être supérieure à 200 nm, voire supérieure à 250 nm, voire encore supérieure à 300 nm, mieux supérieure à 350 nm, étant par exemple de l'ordre de 400 à 500 nm.

### Couches barrière

Dans un mode de réalisation, le module photovoltaïque peut comporter une unique couche barrière telle que décrite ci-dessus.

La couche barrière peut être disposée entre la couche de protection transparente en verre disposée en face avant et l'encapsulant. En variante, elle peut être disposée entre la couche de protection en verre disposée en face arrière et l'encapsulant.

La couche barrière peut être disposée en contact direct avec la couche de protection en verre et l'encapsulant.

En variante, notamment dans le cas où le module photovoltaïque comporte une couche de protection transparente en verre disposée en face avant et une couche de protection en verre disposée en face arrière, le module photovoltaïque peut comporter au moins deux couches barrières, chacune disposée entre l'une des couches de protection et l'encapsulant, chacune des couches barrière comportant au moins 95 % en masse de SiOxNy,
avec x + y = 2, et notamment x ≥ y, et notamment avec x non nul, x ≥ y et x + y = 2, notamment pour la couche barrière disposée du côté de la face avant.

Dans un mode de réalisation, le module photovoltaïque peut comporter deux couches barrières. Les deux couches barrière peuvent être semblables ou différentes, notamment de par leur composition et/ou leur épaisseur.

L'une ou les deux couches barrières peuvent comporter l'une ou plusieurs des caractéristiques mentionnées ci-dessus en référence à la couche barrière.

La couche barrière disposée du côté de la face arrière du module photovoltaïque peut être plus épaisse et/ou comporter une proportion plus importante d'azote. Une telle couche barrière peut être plus résistante.

La couche barrière disposée du côté de la face arrière du module photovoltaïque peut comporter au moins 95 % en masse de SiOxNy, avec x + y = 2, et notamment y ≥ x. La couche barrière disposée du côté de la face arrière du module photovoltaïque peut comporter au moins 96 % en masse de SiN2, voire au moins 97 %, voire encore au moins 98 %, mieux au moins 99 % en masse de SiN2. La couche barrière peut comporter uniquement du SiN2.

La couche barrière disposée du côté de la face avant du module photovoltaïque peut être moins épaisse et/ou comporter une proportion moins importante d'azote. Une telle couche barrière peut être plus transparente.

La couche barrière disposée du côté de la face avant du module photovoltaïque peut comporter au moins 95 % en masse de SiOxNy, avec x + y = 2, et notamment x ≥ y. La couche barrière disposée du côté de la face avant du module photovoltaïque peut comporter au moins 96 % en masse de SiO2, voire au moins 97 %, voire encore au moins 98 %, mieux au moins 99 % en masse de SiO2. La couche barrière peut comporter uniquement du SiO2.

Au moins une cellule photovoltaïque, voire toutes les cellules photovoltaïques, peuvent être des cellules contenant du silicium et/ou une pérovskite. Dans un mode de réalisation, au moins une cellule photovoltaïque, voire toutes les cellules photovoltaïques, sont des cellules silicium à hétérojonction, dites SHJ. De telles cellules peuvent être sensibles à l'humidité. L'utilisation de la couche barrière selon l'invention permet d'éviter que ces cellules SHJ soient contaminées par des dégradations dues à l'humidité, notamment provenant de la ou des couches de protection transparentes en verre.

Dans un mode de réalisation, la ou des couches de protection transparentes en verre comportant du sodium. Le sodium présent dans la ou les couches de verre peut être susceptible de migrer vers les cellules photovoltaïques, notamment dans des conditions humides, et de provoquer une dégradation des cellules. L'utilisation de la couche barrière selon l'invention permet d'éviter avantageusement une telle contamination.

La ou les couches de protection transparentes en verre peuvent être texturées, comportant par exemple des microreliefs.

### Procédé de fabrication

L'invention a encore pour objet, indépendamment ou en combinaison avec ce qui précède, un procédé de fabrication d'un module photovoltaïque tel que décrit plus haut.

En variante, l'invention a pour objet, indépendamment ou en combinaison avec ce qui précède, un procédé de fabrication d'un module photovoltaïque, comportant une face avant et une face arrière, le module photovoltaïque comportant un empilement multicouche comprenant au moins :
- une première couche de protection transparente en verre, notamment disposée en face avant,
- un encapsulant en matériau polymère, par exemple de type élastomère transparent, dans lequel est encapsulé ou enrobé au moins une cellule photovoltaïque, voire des cellules photovoltaïques, et
- une deuxième couche de protection, notamment disposée en face arrière du module, notamment en verre ou à base de polymères multicouches définissant une face arrière, transparente ou non transparente,

procédé dans lequel on vient déposer sur la couche de protection transparente en verre une couche barrière, disposée entre la couche de protection transparente en verre et l'encapsulant, la couche barrière comportant au moins 95 % en masse de SiOxNy,
avec x + y = 2, et notamment x ≥ y, et notamment avec x non nul, x ≥ y et x + y = 2,
puis on procède à l'empilement de la couche de protection transparente en verre sur l'encapsulant.

Le module photovoltaïque peut comporter l'une ou plusieurs des caractéristiques mentionnées ci-dessus en référence au module photovoltaïque et à la couche barrière.

L'empilement peut être laminé avec la ou les cellules photovoltaïques, par exemple à 160°C pendant une durée de 18 min.

La couche barrière selon l'invention peut être mise en place dès la fabrication du dispositif photovoltaïque.

L'empilement est effectué en plaçant la couche barrière entre la couche de protection transparente en verre et l'encapsulant. La couche de protection en verre est orientée dans l'empilement de sorte que la couche barrière est placée vers l'encapsulant de la ou des cellules photovoltaïques.

Dans l'invention, on vient déposer la couche barrière sur la ou les couches de protection transparente en verre, et non pas sur la ou les cellules photovoltaïques.

Le dépôt de la couche barrière a lieu avant l'empilement multicouche du module photovoltaïque. Ainsi, la ou les couches de protection transparente en verre incorporent dès leur fabrication une couche barrière permettant d'améliorer la durabilité du module photovoltaïque.

Le dépôt de la couche barrière peut être effectué pendant une durée comprise entre 5 et 45 minutes, voire entre 7 et 40 min, voire encore entre 9 et 30 min, mieux entre 10 et 25 min, étant par exemple de l'ordre de 12 à 20 min.

Le choix de la durée du dépôt peut dépendre de l'épaisseur de la couche souhaitée, ainsi que de la pression choisie.

La durée de dépôt peut être suffisante afin de permettre le dépôt d'une couche barrière d'épaisseur suffisante, avec une quantité de matière déposée suffisante pour obtenir une protection satisfaisante.

La durée de dépôt peut ne pas être trop longue afin d'éviter de limiter la transparence de la couche barrière, et également d'éviter que le procédé de fabrication ne soit trop long.

Le dépôt de la couche barrière peut être effectué par une technique de dépôt choisie dans la liste suivante, qui n'est pas limitative : dépôt physique en phase vapeur (en anglais PVD « *physical vapor deposition* »), dépôt chimique en phase vapeur assisté par plasma (en anglais PECVD « *Plasma-Enhanced Chemical Vapor Deposition* »), dépôt de couches atomiques (en anglais ALD « *Atomic Layer Deposition* »), dépôt chimique en phase vapeur à pression atmosphérique (en anglais APCVD « *Atmospheric Pressure Chemical Vapor Deposition »).*

Le dépôt de la couche barrière peut être effectué par dépôt chimique en phase vapeur de gaz N2O et SiH4. Un ratio du débit de N2O sur le débit de SiH4 peut être compris entre 8 et 30, étant par exemple de l'ordre de 13 à 14. Le débit peut être mesuré en centimètres cubes standard par minute (sccm). Le débit de N2O peut être compris entre 200 sccm et 10 000 sccm, étant par exemple de l'ordre de 6000 sccm. Le débit de SiH4 peut être compris entre 200 sccm et 2000 sccm, v, étant par exemple de l'ordre de 450 sccm.

La pression peut être comprise entre 66 Pa et 267 Pa, étant par exemple de l'ordre de 120 Pa.

La température peut être comprise entre 100°C et 500°C, étant par exemple de l'ordre de 450°C.

### Brève description des dessins

L'invention pourra être mieux comprise à la lecture de la description détaillée qui va suivre, d'exemples de réalisation non limitatifs de celle-ci, et à l'examen du dessin annexé, sur lequel :
[Fig 1] La figure 1 est une vue en perspective, schématique et partielle, d'un module photovoltaïque.
[Fig 2] La figure 2 est une vue en coupe, schématique et partielle, du module photovoltaïque de la figure 1.
[Fig 3] La figure 3 est une vue en coupe, schématique et partielle, du module photovoltaïque de la figure 1.
[Fig 4] La figure 4 est une vue en coupe, schématique et partielle, d'une variante de réalisation.
[Fig 5] La figure 5 est une vue en coupe, schématique et partielle, d'une variante de réalisation.
[Fig 6] La figure 6 illustre, de manière schématique et partielle, le dépôt de la couche barrière.
[Fig 7] La figure 7 illustre l'évolution de la puissance maximale Pmax en fonction du temps de vieillissement et en fonction de l'épaisseur du dépôt de la couche barrière.

### Description détaillée

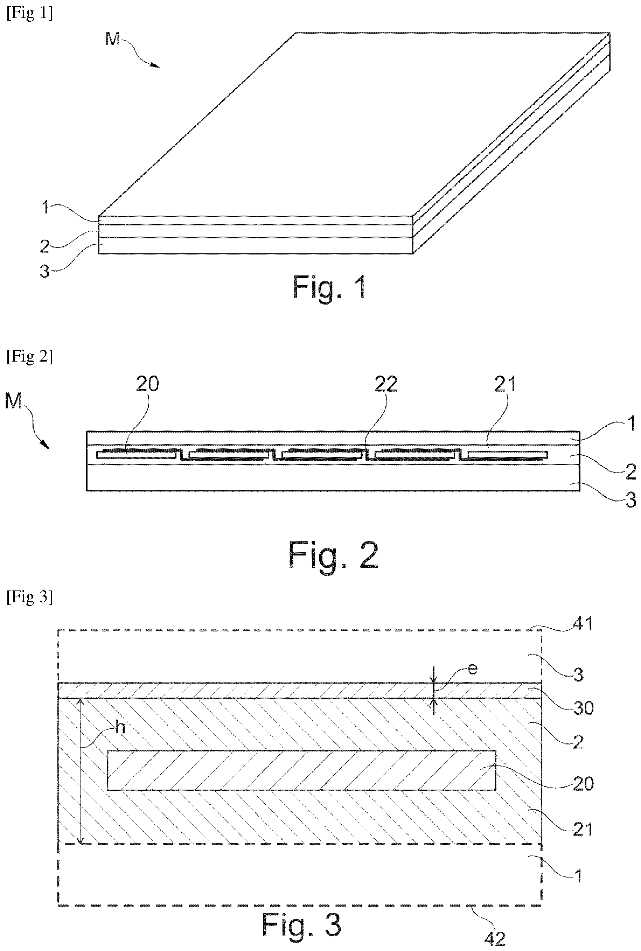

On a illustré aux figures 1 à 3 un module photovoltaïque M comportant une face avant 41 et une face arrière 42, le module photovoltaïque comportant un empilement multicouche comprenant plusieurs couches superposées et assemblées entre elles, comme suit :
- Une première couche de protection 3 en face avant ; cette première couche de protection 3 étant notamment en verre, par exemple en verre trempé transparent d'épaisseur d'environ 2 à 3 mm,
- Une deuxième couche de protection 1 (appelée couramment "*backsheet*") en face arrière ; cette deuxième couche de protection 1 est habituellement réalisée notamment en verre ou à base de polymères multi-couches ; elle peut être opaque ou transparente, monocouche ou multicouche ;
- Une troisième couche 2 d'encapsulant, dite couche intermédiaire, intercalée entre la première couche et la troisième couche, décrite ci-dessous, permettant l'assemblage d'un côté de la première couche de protection 3 et de l'autre côté de la deuxième couche de protection 1 ; cette couche intermédiaire comportant une ou des cellules photovoltaïques 20, la connectique électrique 22 et un encapsulant 21 arrangé autour des cellules photovoltaïques.

Il faut noter que sur les figures annexées, le module photovoltaïque M est représenté retourné, de sorte que sa face arrière est située au-dessus et la face avant est située au-dessous. Pour des soucis de lisibilité sur les figures, les différentes couches du module ne sont pas représentées à l'échelle. A titre d'exemple, la deuxième couche de protection 1 peut présenter une épaisseur de quelques centaines de micromètres, par exemple environ 350 µm, la troisième couche 2 peut présenter une épaisseur pouvant aller jusqu'à 1 mm et la première couche de protection 3 peut présenter une épaisseur d'environ 3 à 4 mm.

Dans la suite de la description, la face avant du module photovoltaïque M correspond à une face du module recevant les rayons lumineux et la face arrière correspond à la face opposée à la face avant. Les deux couches de protection 1 et 3 peuvent présenter une fonction de rigidification et/ou une fonction de protection de surface.

La deuxième couche de protection 1 peut notamment assurer une fonction d'imperméabilité aux gaz et à l'eau, une fonction de protection/isolation électrique et une fonction de protection mécanique. Cette deuxième couche de protection 1 peut être réalisée à base de verre ou d'un polymère fluoré. Il peut s'agir du polyfluorure de vinyle (PVF), par exemple commercialisé sous le nom TEDLAR (marque déposée) par la société DuPont (marque déposée). De manière non limitative, la deuxième couche 1 peut elle-même être composée d'un empilement de plusieurs strates : une strate de PVF, une strate en PET (poly(téréphtalate) d'éthylène), une strate de PVF.

Dans la couche intermédiaire 2, l'encapsulant 21 est par exemple de type élastomère transparent, étant par exemple réalisé dans un polymère tel que de l'EVA (Ethylène-Acétate de Vinyl) ou du POE formant un matériau sur lequel peuvent adhérer la deuxième couche de protection 1 d'un côté et la première couche de protection 3 de l'autre côté et permettre l'assemblage des trois couches entre elles.

Les trois couches peuvent être assemblées entre elles par laminage à chaud, de sorte que la première couche et la deuxième couche viennent adhérer au matériau de l'encapsulant 21, formant ainsi un empilement monobloc.

Dans la couche intermédiaire d'encapsulant 2, les cellules photovoltaïques 20 sont connectées entre elles, en série/parallèle, formant plusieurs chaînes ("*string*" en anglais) de cellules. Des éléments de connexion électrique 22, par exemple en cuivre ou en argent, permettent d'assurer les liaisons électriques entre les cellules 20 dans chaque chaîne.

Le module photovoltaïque M peut comporter un cadre (non représenté), par exemple en aluminium, agencé en périphérie de l'empilement pour rigidifier le module M.

Le module photovoltaïque M comporte en outre au moins une couche barrière 30, disposée entre la couche de protection transparente en verre et l'encapsulant, la couche barrière 30 comportant au moins 95 % en masse de SiOxNy, avec x + y = 2.

Dans un cas particulier, on peut avoir x non nul, x ≥ y et x + y = 2. Les valeurs de x et y peuvent varier respectivement dans les intervalles ]0 ;2] et [0 ;2[. Les valeurs de x et y peuvent être respectivement de 1 et 1 ou encore de 2 et 0. Les valeurs de x et y peuvent être des nombres décimaux.

Dans un cas particulier, la couche barrière peut être disposée en contact direct avec la couche de protection en verre et l'encapsulant.

Comme visible schématiquement sur la figure 3, la couche barrière 30 est sensiblement continue et comporte une épaisseur e sensiblement uniforme, laquelle peut être de l'ordre de 110 à 150 nm.

En outre, l'épaisseur h de l'encapsulant peut être par exemple de l'ordre de 400 à 500 nm.

Dans le mode de réalisation de la figure 3, le module photovoltaïque comporte une unique couche barrière, qui est disposée entre la couche de protection 3 transparente en verre disposée en face avant et l'encapsulant 2.

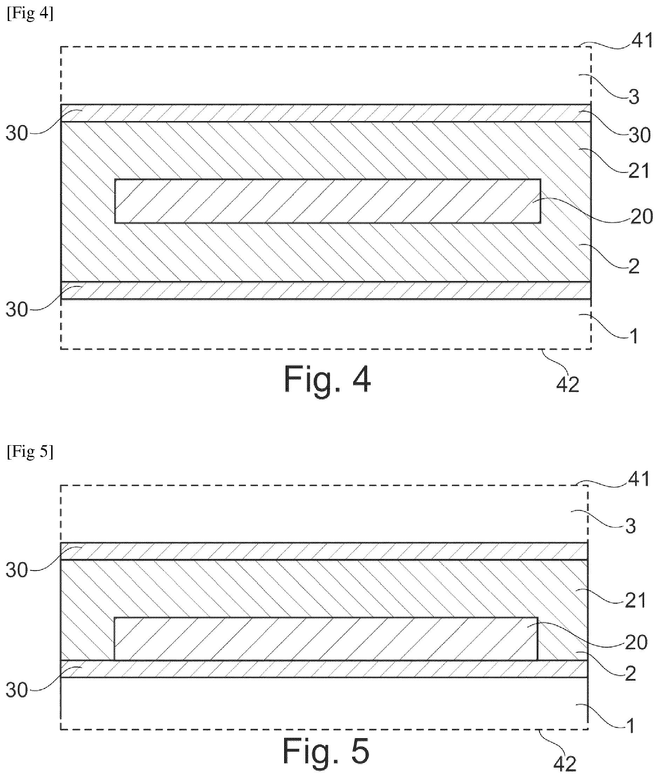

Dans une variante illustrée à la figure 4, le module photovoltaïque comporte une couche de protection 3 transparente en verre disposée en face avant et une couche de protection 1 en verre disposée en face arrière. Le module photovoltaïque M comporte alors deux couches barrières 30, chacune disposée entre l'une des couches de protection 1, 3 en verre et l'encapsulant 2, chacune des couches barrière comportant au moins 95 % en masse de SiOxNy, avec x + y = 2, et dans un cas particulier avec x non nul, x ≥ y et x + y = 2. Les deux couches barrière 30 peuvent être semblables ou différentes, notamment de par leur composition et/ou leur épaisseur.

Dans les modes de réalisation qui viennent d'être décrits, l'encapsulant 2 entoure complètement la ou les cellules photovoltaïques 20.

En variante, comme illustré à la figure 5, l'encapsulant 2 recouvre la ou les cellules photovoltaïques 20 d'un seul côté de celles-ci. Le module photovoltaïque M de la figure 5 comporte également deux couches barrières 30, chacune disposée entre l'une des couches de protection 1, 3 en verre et l'encapsulant 2.

Dans les modes de réalisation qui viennent d'être décrits, la ou les cellules photovoltaïques 20 peuvent être des cellules contenant du silicium et/ou un pérovskite, étant par exemple des cellules silicium à hétérojonction, dites SHJ. En outre, la ou les couches de protection 30 en verre comporte du sodium.

On va maintenant décrire un procédé de fabrication d'un module photovoltaïque M par exemple tel que décrit précédemment.

Dans une première étape, on vient déposer sur la couche de protection 3 transparente en verre une couche barrière 30, disposée entre la couche de protection 3 transparente en verre et l'encapsulant 2, la couche barrière 30 étant tel que décrite précédemment.

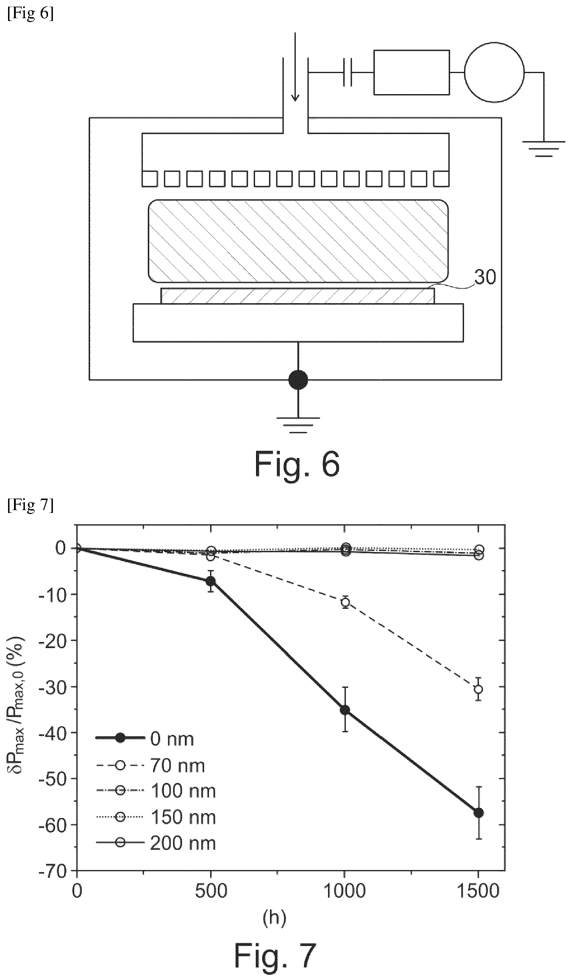

Le dépôt est dans cet exemple effectué par dépôt chimique en phase vapeur assisté par plasma (en anglais PECVD « *Plasma-Enhanced Chemical Vapor Deposition* »), comme illustré à la figure 6, en utilisant les gaz N2O et SiH4, un ratio du débit de N2O sur le débit de SiH4 étant par exemple de l'ordre de 12 à 13. Le débit est mesuré en centimètres cubes standard par minute (sccm). Le débit de N2O est par exemple de l'ordre de 6000 sccm. Le débit de SiH4 est par exemple de l'ordre de 450 sccm.

Le dépôt de la couche barrière est effectué pendant une durée qui est par exemple de l'ordre de 12 à 20 min. La pression est par exemple de l'ordre de 900 mT. La température est par exemple de l'ordre de 450°C.

Dans une deuxième étape, on procède à l'empilement de la couche de protection 3 transparente en verre sur l'encapsulant 2.

L'empilement est effectué en plaçant la couche barrière 30 entre la couche de protection 3 transparente en verre et l'encapsulant. La couche de protection 3 en verre est orientée dans l'empilement de sorte que la couche barrière 30 est placée vers l'encapsulant de la ou des cellules photovoltaïques.

L'empilement est ensuite laminé, par exemple à 160°C pendant une durée de 18 min.

### Exemple

On met en œuvre le procédé avec les paramètres suivants : un ratio du débit de N2O sur le débit de SiH4 est de l'ordre de 12 à 13. Le dépôt de la couche barrière est effectué pendant une durée qui est de l'ordre de 12 à 20 min. Le débit de N2O est de l'ordre de 6000 sccm. Le débit de SiH4 est de l'ordre de 450 sccm. La pression est de l'ordre de 900 mT. La température est de l'ordre de 450°C. La puissance est de l'ordre de 8000 W.

L'empilement du module est ensuite réalisé comme présenté sur la Figure 4 avec les faces de couches barrière placées côté cellule photovoltaïque vers l'intérieur du module photovoltaïque. Les matériaux utilisés sont les suivants :
- 2 plaques de verre sodocalcique 20 x 20 cm² avec dépôt de couche barrière,
- 2 feuilles d'encapsulant de type TPO 20 x 20 cm²,
- 2 demi-cellules de technologie silicium hétérojonction interconnectées par cordage ECA (en anglais *stringing ECA*).

La lamination du module photovoltaïque est ensuite réalisée à 160 °C durant un cycle de 18 min.

Le dépôt de couches barrière de 70, 100, 150 et 200 nm permet de tester l'influence de l'épaisseur de la couche barrière sur la qualité de la protection.

Le Tableau 1 présente les performances initiales I_{SC} des modules photovoltaïques et montre que l'épaisseur du dépôt n'a pas d'influence sur la transparence et donc les performances initiales des modules photovoltaïques.

**[Tableau 1]**

| **Performances initiales** | **0 nm** | **70 nm** | **100 nm** | **150 nm** | **200 nm** |
|---|---|---|---|---|---|
| ***Isc*** | 4.68 ± 0.02 | 4.67 ± 0.02 | 4.73 ± 0.04 | 4.72 ± 0.03 | 4.73 ± 0.00 |
| Tableau 1 : Performances initiales (I_{SC}) des modules photovoltaïques | | | | | |

Le module subit ensuite 1500 h de vieillissement sous chaleur humide (damp heat = DH), selon la norme IEC 61215 (85 °C / 85 % RH). Les vieillissements sont réalisés avec une enceinte ESPEC. Les résultats obtenus sont présentés à la figure 7, en comparaison avec des modules photovoltaïques identiques mais sans la couche barrière sur le verre. La Figure 7 présente l'évolution de la puissance maximale Pmax des différentes configurations avec différentes épaisseurs de couche barrière, en fonction du temps de vieillissement en DH exprimé en heures et en fonction de l'épaisseur du dépôt exprimée en nanomètres.

Nous constatons une différence notable de la dégradation des paramètres électriques pour les modules avec et sans couche barrière. Les modules photovoltaïques avec couche barrière SiOx se dégradent nettement moins que ceux sans couche barrière. Le dépôt de cette couche barrière apporte donc une protection face à la dégradation à l'ensemble du module photovoltaïque.

## Revendications

1. Module photovoltaïque (M), comportant une face avant (41) et une face arrière (42), le module photovoltaïque comportant un empilement multicouche comprenant au moins :
- une première couche de protection transparente en verre en face arrière (42),
- un encapsulant (2) en matériau polymère, par exemple de type élastomère transparent, dans lequel est encapsulé ou enrobé au moins une cellule photovoltaïque (20), voire des cellules photovoltaïques (20),
- une deuxième couche de protection (1), et
- au moins une couche barrière (30), disposée entre la couche de protection transparente en verre en face arrière (42) et l'encapsulant (2), la couche barrière (30) comportant au moins 95 % en masse de SiOxNy,
avec x + y = 2, et notamment x ≥ y.

2. Module selon la revendication précédente, la couche barrière (30) comportant 57% de O2, 39% de Si et 4% de N.

3. Module selon l'une quelconque des revendications précédentes, une épaisseur (e) de la couche barrière (30) étant supérieure à 50 nm, voire supérieure à 70 nm, voire supérieure à 80 nm, voire encore supérieure à 90 nm, mieux supérieure à 100 nm, étant par exemple de l'ordre de 110 à 150 nm.

4. Module selon l'une quelconque des revendications précédentes, la première couche de protection transparente en verre étant disposée en face avant du module.

5. Module selon l'une quelconque des revendications précédentes, la deuxième couche de protection (1) étant disposée en face arrière (42) du module, étant notamment en verre ou à base de polymères multicouches définissant une face arrière.

6. Module selon l'une quelconque des revendications précédentes, l'encapsulant (2) entourant complètement la ou les cellules photovoltaïques (20).

7. Module selon l'une quelconque des revendications 1 à 3, l'encapsulant (2) recouvrant la ou les cellules photovoltaïques (20) d'un seul côté de celles-ci.

8. Module selon l'une quelconque des revendications précédentes, l'encapsulant comportant au moins un matériau d'encapsulation de type polymère choisi parmi : les copolymères d'acides, les ionomères, le poly(éthylène-acétate de vinyle) (EVA), les acétals de vinyle, tels que les polyvinylbutyrals (PVB), les polyuréthanes, les polyéthylènes, tels que les polyéthylènes linéaires basse densité, les polyoléfines élastomères de copolymères, les copolymères d'α-oléfines et des α-, β- esters d'acide carboxylique à éthylénique, tels que les copolymères éthylène-acrylate de méthyle et les copolymères éthylène-acrylate de butyle, les élastomères de silicone et/ou les élastomères à base de polyoléfine thermoplastique réticulée.

9. Module selon l'une quelconque des revendications précédentes, comportant au moins deux couches barrières (30), chacune disposée entre l'une des couches de protection et l'encapsulant (2), chacune des couches barrière (30) comportant au moins 95 % en masse de SiOxNy,
avec x + y = 2, et notamment x ≥ y.

10. Module selon l'une quelconque des revendications précédentes, au moins une cellule photovoltaïque (20), voire toutes les cellules photovoltaïques (20), étant des cellules silicium à hétérojonction, dites SHJ.

11. Module selon l'une quelconque des revendications précédentes, la ou des couches de protection transparentes en verre comportant du sodium.

12. Module selon l'une quelconque des revendications précédentes, la couche barrière (30) étant disposée en contact direct avec la couche de protection transparente en verre et l'encapsulant (2).

13. Procédé de fabrication d'un module photovoltaïque (M), comportant une face avant (41) et une face arrière (42), le module photovoltaïque (M) comportant un empilement multicouche comprenant au moins :
- une première couche de protection transparente en verre, notamment disposée en face arrière (42),
- un encapsulant (2) en matériau polymère, par exemple de type élastomère transparent, dans lequel est encapsulé ou enrobé au moins une cellule photovoltaïque (20), voire des cellules photovoltaïques (20), et
- une deuxième couche de protection, notamment disposée en face avant (41) du module, notamment en verre ou à base de polymères multicouches définissant une face arrière,
procédé dans lequel on vient déposer sur la couche de protection transparente en verre en face arrière (42) une couche barrière (30), disposée entre la couche de protection transparente en verre en face arrière (42) et l'encapsulant (2), la couche barrière comportant au moins 95 % en masse de SiOxNy,
avec x + y = 2, et notamment x ≥ y , notamment avec x non nul, x ≥ y et x + y = 2,
puis on procède à l'empilement de la couche de protection transparente en verre sur l'encapsulant (2).

14. Procédé selon la revendication précédente, le dépôt de la couche barrière (30) étant effectué pendant une durée comprise entre 5 et 45 minutes, voire entre 7 et 40 min, voire encore entre 9 et 30 min, mieux entre 10 et 25 min, étant par exemple de l'ordre de 12 à 20 min.

15. Procédé selon l'une des deux revendications précédentes, le dépôt de la couche barrière étant effectué par une technique de dépôt choisie dans la liste suivante : dépôt physique en phase vapeur (en anglais PVD « *physical vapor deposition* »), dépôt chimique en phase vapeur assisté par plasma (en anglais PECVD « *Plasma-Enhanced Chemical Vapor Deposition* »), dépôt de couches atomiques (en anglais ALD « *Atomic Layer Deposition* »), dépôt chimique en phase vapeur à pression atmosphérique (en anglais APCVD « *Atmospheric Pressure Chemical Vapor Deposition* »)*.*

16. Procédé selon l'une des trois revendications précédentes, dans lequel le dépôt de la couche barrière est effectué par dépôt chimique en phase vapeur de gaz N2O et SiH4, un ratio du débit de N2O sur le débit de SiH4 étant compris entre 8 et 30, étant par exemple de l'ordre de 13 à 14.
